# EUROPEAN PATENT APPLICATION

(11) **EP 2 495 767 A1**
(43) Date of publication of application: **05.09.2012**
(21) Application number: 11177972.4
(22) Date of filing: 18.08.2011
(51) Int. Cl.: H01L 31/02, H01L 31/05, H01L 31/048

(54) **Hollow wire raceway and flexible photovoltaic cell membrane system**

(30) Priority: 01.03.2011 US 37549
(71) Applicant: Carlisle Intangible Company, Syracuse NY 13202-1258 (US)
(72) Inventor: Gillenwater, Richard, Carlisle, PA Pennsylvania 17015 (US)
(74) Representative: Findlay, Alice Rosemary

(57) **Abstract**

A flexible photovoltaic system for use on a landfill roof or other area includes a flexible membrane (22) and flexible photovoltaic cells bonded to the membrane. Wires (48,106) which connect various components of the system run in hollow protective raceways (104a). The raceways include a hollow central arcuate portion (116) and bonding flanges (112,114) on either side. Wires are inserted in the hollow portion through a slit (124) in the bottom of the raceway. The raceways are bonded to the membrane by welding or adhering the flanges to the membrane.

## Description

There are a variety of types of photovoltaic cells. Some are relatively rigid panels. Others are flexible panels or sheets. These flexible photovoltaic cells have been attached to roof membranes. This is disclosed, for example, in Laaly et al. US patent 4,860,509.

Generally, flexible photovoltaic systems attached to roof membranes have been used on flat roofs, i.e., having a low slope. However, these flexible photovoltaic systems are now being used on more steeply sloped surfaces, and are particularly useful for covering landfills. The membrane prevents water from seeping into the top of the landfill and prevents landfill gases from escaping into the atmosphere. Further, the landfill, which is generally not suited for other uses, can be used to generate electricity.

Locating a photovoltaic system attached to a flexible membrane on a sloped surface is different from locating it on a generally flat roof surface. With a sloped surface, one must deal with significant water flow, as well as snow and ice, which flow down the surface. The flowing water, snow and/or ice create forces which tend to separate the wiring or photovoltaic cells from the membrane.

These systems use several photovoltaic cells which are wired together and connect to a battery or to the power grid. The present wire trace systems used to carry the wiring at or above the membrane surface are generally attached to the membrane that supports the photovoltaic cell.

An alternative to the above membrane installation is to bury the wiring in conduit under the membrane. This is a viable option but is costly and difficult to service. In landfill applications, this buried conduit is subjected to forces caused by the setting that occurs as these landfills age. This settling is the result of decomposition and liquid runoff of the contents of the landfill and can generate great forces that can lead to conduit - wiring failure.

Accordingly, it is an object of the present invention to provide a flexible photovoltaic cell membrane system wherein the wiring between the photovoltaic, cells remains above the surface of the membrane and is protected from the elements, in particular water, snow and ice.

To protect the wiring, the wiring is at least partially encased in a low profile hollow protective member or raceway. The raceway is made from a thermoplastic polymer and includes bonding flanges allowing the raceway to be bonded to the membrane anywhere along the membrane. This protects the wiring from external forces and facilitates installation of the wiring.

The invention will now be further described by way of example with reference to the accompanying drawings, in which:

FIG. 1 is a perspective view of the present invention;

FIG. 2 is an enlarged portion of FIG. 1 broken away, showing electrical connections in phantom;

FIG. 3 is an enlarged portion broken away of the area delineated by Box 3 of FIG. 2,

FIG. 4 is a cross-sectional view taken at lines 4-4 of FIG. 1 ;

FIG. 5 is an overhead view of the raceway used in the present invention;

FIG. 6 is a cross sectional view taken at line 6-6 of FIG. 3 of the raceway of the present invention;

FIG. 7 is a cross sectional view of an alternate embodiment of the present invention;

FIG. 8 is a perspective view of a connector being assembled;

FIG. 9 is a perspective view partially broken away showing two raceways connected together, and

FIG. 10 is a perspective view of an "L" shaped connector.

A flexible photovoltaic cell system 10 is located over a sloped surface 12. Generally, a sloped surface can have a slope of 25:12 or greater. This can be a sloped roof or a sloped landfill area 12. The drawings show a landfill area 12. (However the numeral 12 could also designate a sloped roof surface.) The landfill 12 will typically be sloped, having an uphill side 14 and a downhill side 16. The general slope of the landfill is shown by arrow 18. Flexible photovoltaic system 10 includes a flexible polymeric membrane 22, and as shown, a first array 24 and a second array 26 of individual flexible photovoltaic cells 28. The number of membranes and cells will vary depending on the area being utilized.

Each of the individual cells 28 is fixed to the membrane 22 by well-known methods. Typically, the cells 28 are either adhered or heat-welded to the membrane 22.

The membrane can be any membrane suitable for exterior use, such as PVC, EPDM, TPO, HDPE, and LLDPE, and the like, One membrane particularly suitable for use in the present invention is a fiber-reinforced TPO membrane. The fiber reinforcement allows the membrane to withstand stresses encountered during movement of the landfill, which may occur during compaction of the soil and the like.

The individual cells 28 are located side by side on the membrane 22 with spacing 38 between the cells. Each cell 28 includes a top 32 and a bottom 34. The top 32 includes the electrical connections, including the positive and negative leads 42 and 44, which in turn lead to wires 48 and 50, in turn leading to connectors 54 and 56.

The top portions 32 of the arrays of the cell 28 are preferably covered with an elongated, narrow, continuous, flap 60. The flap 60, which can be formed from the same material as the membrane 22 or a different material such as metal or rubber coated metal, is bonded along a top edge 62 to the membrane 22. The flap 60 extends from above the array of cells over the electrical connections to a point so that the free edge 64 of the flap 60 lies downhill from the electrical connections.

If the flap is a more rigid material, which will not move under windy conditions, it does not need to be further connected to the membrane 22. However, if the flap 60 is, for example, a flap of a polymeric material, such as for example the same material from which the membrane is formed, it may be desirable to fix the bottom edge 64 to the membrane 22.

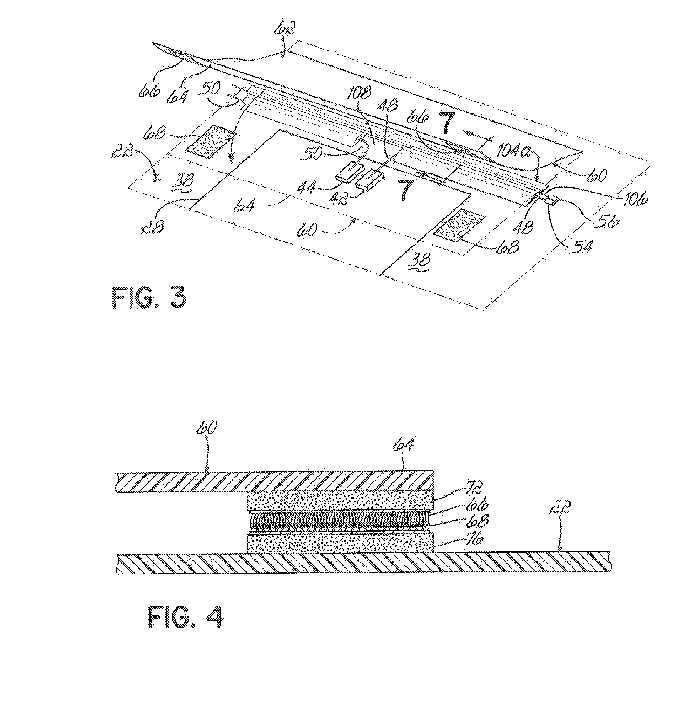

Accordingly, as shown in FIG.4, the flap includes a first complementary fastener 66 and the membrane includes a second complementary fastener 68, which is located in the spacing 38 between the individual cells 28. The first complementary fastener 66 can be a hook portion, bonded with an adhesive 72 to bottom edge 64 of flap 60. In turn, the membrane 22 includes a pile portion as the second complementary fastener 68 bonded to the membrane 22 with an adhesive 76. Thus, the fastener members 66 and 68 as shown in FIG. 4 would comprise a hook and pile fastener.

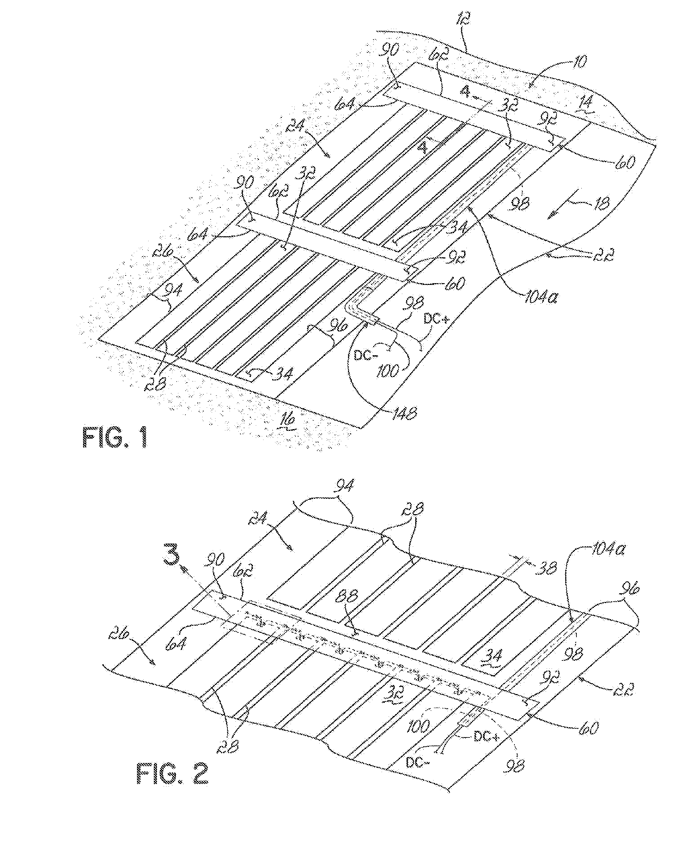

As shown more particularly in FIG. 2, the upper array 24 is separated from the bottom array 26 by a slight spacing 88. Both the top and bottom arrays incorporate a flap 60, with each flap 60 extending completely across the top of each array, with the side portions 90 and 92, which extend slightly beyond the array, leaving 6 inch edge portions 94 and 96 of the membrane 22 along either side to allow adjacent membranes to be adhered side by side together if desired (although no such additional membranes are shown in the drawings.)

The membrane 22 is held to the landfill by, for example, burying the edges of the membrane in trenches in the landfill. Other mechanical fastening mechanisms can also be used. A typical system is disclosed, for example, in published PCT application WO 2009/105483.

Preferably, the photovoltaic cell system 10 will be manufactured offsite by adhering the cells 28 in the arrays 24 or 26 to the membrane 22. The flaps 60 are then heat-welded or adhered to the membrane 22 covering the electrical connections as shown in FIG. 1.

As shown in FIG. 3, the wires 48 and 50 run through a protective sleeve or raceway 104a. Wires 48 and 50 from the connectors 42 and 44 extend through a cut out portion 108 of the raceway 104a. Also shown is a wire 106 that runs through the length of the raceway which simply connects to the final lead of the final cell. Additional wires 98 and 100 can lead to adjacent photovoltaic systems or can be directed to batteries or converters as desired. The wiring shown is exemplary. Depending on the layout of the system, there can be many additional wires at different locations throughout the system.

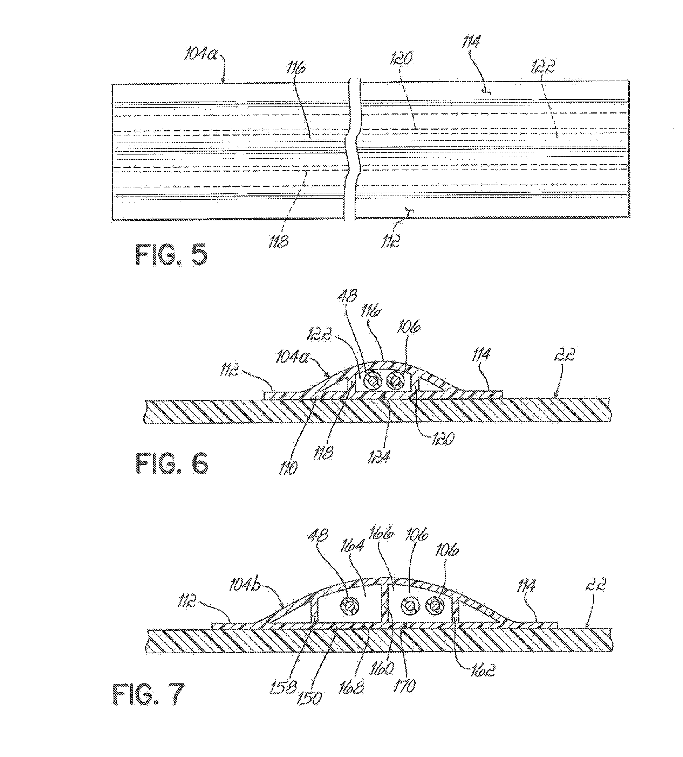

Raceway 104a is shown in FIG. 5 without the cutout 108. Sleeves or raceways 104a include a planar baste 110 with first and second flanges 112,114 on either side of the base 110. Extending between the flanges is an arcuate raised section 116 extending above the base.

As shown in FIG. 6, first and second support walls 118,120 extend from the base 110 to support the arcuate section 116. Between support walls 118 and 120 is a central axial hollow portion 122 which extends the length of the raceway 104a, which is open at either end. The base 110 further includes an axial slit 124 aligned with the hollow portion 122. This allows the wires to be inserted into the raceway prior to attachment of the raceway to the membrane.

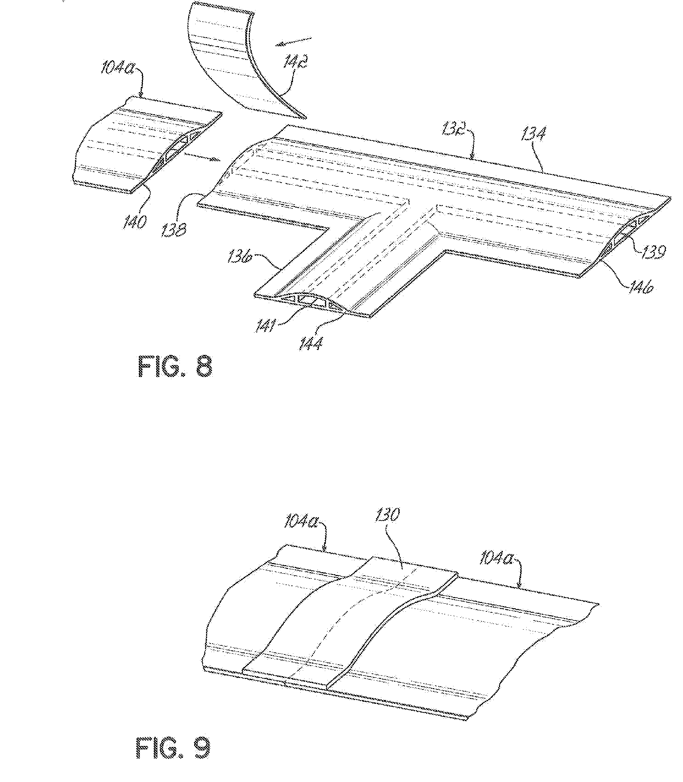

Once it is determined where wires should be located, the wires are inserted into the hollow portion 120 of raceways 104a through slits 124. As shown in FIG. 9, if the raceways 104a are too short and added length is required, a second raceway can simply abut a first raceway against the second raceway, with the wires running there between. These two adjacent raceways are bonded together by a thermoplastic sheet or bonding flap 130, which can be heat welded or solvent bonded to the outer surface of the abutted ends of the two raceways.

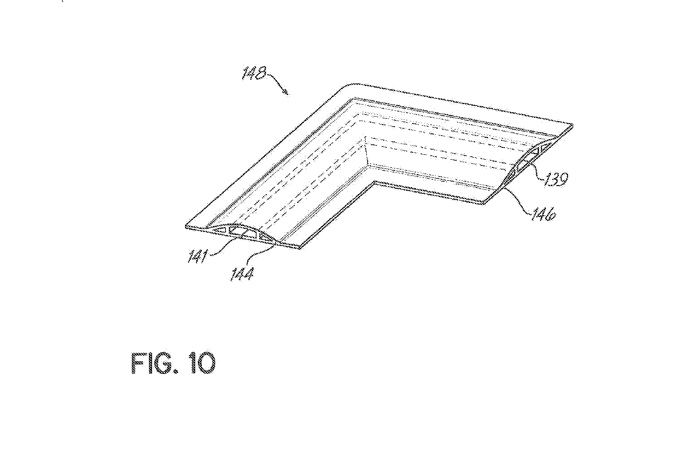

As shown in FIG. 8, if the direction of the wire changes a connector 132 can be used. T-shaped connector 132 includes a first section 134 and a second section 136 perpendicular to the first section. The internal configurations of these are identical to the cross section of the raceway 104a with slits 139,141 on the bottom to allow insertion of the wires. One edge 138 of the connector 132 is simply abutted against an edge 140 of the raceway and the two are bonded together using a thermoplastic sheet or bonding flap 142 bonded to the two. The thermoplastic sheet 142 not only bonds the two together but also seals the interior of the respective raceways. The additional raceways would then be attached to edges 144 and 146 of the T-shaped connector 132 in the same manner. An L-shaped connector 148 is shown in FIG. 10.

As the raceways are assembled and wires inserted, the raceways are bonded to the thermoplastic sheet by bonding the flanges to the sheet. The bond can either be continuous along each flange, or the flanges can be spot welded or bonded to the membrane. The welding can be done through application of heat directly to the flanges, causing them to melt and adhere to the membrane surface, or a solvent can be applied to the bottom of the flange and to the membrane, allowing the two to bond together. The raceways can also be adhered to the membrane using compatible adhesives or a two-sided tape commonly used in roofing applications.

An alternate raceway 104b is shown in FIG. 7. This embodiment likewise includes the base 150 with first and second bonding flanges 152,154 and a central arcuate portion 156. Raceway 104b includes three supporting walls 158, 160, 162, which create two axial hollow spaces 164,166. The base 150 includes first and second slits 168,170 aligned with these first and second axial hollow portions 164,166 permitting multiple wires to be located within the hollow portions 164, 166.

This raceway 104b is installed in the same manner as the raceway 104a using similarly sized T-shaped or L-shaped connectors, as needed.

Utilizing the raceways provides several advantages when installing a flexible photovoltaic system. It allows the wiring to be installed at the site in a protective raceway or sleeve. The continuous bonding flanges enable the sleeve to be adhered to the membrane with a continuous bond or with spot welding. The flanges themselves, being relatively thin and planar reduce any forces from ice or water running down the membrane. The raceways also protect the wiring from foot traffic and moisture as well as sun and other detrimental environmental conditions such as ozone, and the like.

The raceways are preferably formed from a thermoplastic material, preferably the same material that the membrane is formed from, and, in this case, typically TPO. These can be formed by extrusion and/or molding. If formed by extrusion, the extruded part would be miter cut and the pieces bonded together to form the "T" or "L" shape. The T-shaped and L-shaped connectors can also be molded in two pieces and then subsequently bonded together.

## Claims

1. A flexible photovoltaic cell system comprising a flexible membrane, a first plurality of flexible photovoltaic cells, a plurality of wires connected to said photovoltaic cells at least one or more of said wires extended through a first raceway having an arcuate central portion having a first hollow passage and planar bonding flanges extended from first and second sides of said central portion, wherein said first raceway is bonded to said membrane along said bonding flanges.

2. The photovoltaic system claimed in claim 1 wherein said bonding flanges extend along a length of said raceway.

3. The photovoltaic system claimed in either claim 1 or claim 2 wherein said raceway includes a bottom panel extending between said bonding flanges and includes an axial slit providing access to said first hollow passage.

4. The photovoltaic system claimed in claim 3 further comprising a second passage parallel to said first passage and said bottom panel includes a second slit providing access to said second passage.

5. The photovoltaic system claimed in any preceding claim wherein said bonding flanges are welded to said membrane.

6. The photovoltaic system claimed in any preceding claim comprising a second raceway bonded end to end to said first raceway by a bonding flap covering and bonded to adjacent end portions of said first and second raceways.

7. The photovoltaic system claimed in claim 6 wherein said second raceway has a "T" shape.

8. The photovoltaic system claimed in claim 6 wherein said second raceway has an "L" shape.
